# EUROPEAN PATENT SPECIFICATION

(11) **EP 2 981 986 B1**
(45) Date of publication and mention of the grant of the patent: **18.08.2021**
(21) Application number: 14702934.2
(22) Date of filing: 31.01.2014
(51) Int. Cl.: H01L 27/146

(54) **IMAGING SENSOR**
BILDGEBUNGSSENSOR
CAPTEUR D'IMAGERIE

(30) Priority: 31.01.2013 GB 201301750
(43) Date of publication of application: 10.02.2016
(73) Proprietor: United Kingdom Research and Innovation, Swindon SN2 1FL (GB)
(72) Inventor: TURCHETTA, Renato Andrea Danilo, Oxford Oxfordshire OX4 4JF (GB); GUERRINI, Nicola Carlo, Oxford Oxfordshire OX10 0PH (GB); GASIOREK, Przemyslaw, Oxford Oxfordshire OX4 2RB (GB)
(74) Representative: Boult Wade Tennant LLP
(86) International application number: PCT/GB2014/050273
(87) International publication number: WO 2014/118561

(56) References cited:
- EP-A1- 1 868 377
- EP-A1- 1 868 377
- EP-A1- 2 405 481
- EP-A1- 2 405 481
- WO-A2-2012/107784
- US-A1- 2006 102 938
- US-A1- 2006 102 938
- US-A1- 2008 079 044
- US-A1- 2008 224 186

## Description

### Technical Field

Imaging sensors, for example, based on active pixel sensor (APS) technology are those in which some processing or amplification of photogenerated charge is included in each pixel. The present invention relates to a sensor having an array of pixels, the dynamic range of each pixel being enhanced over conventional APS technology.

### Background Art

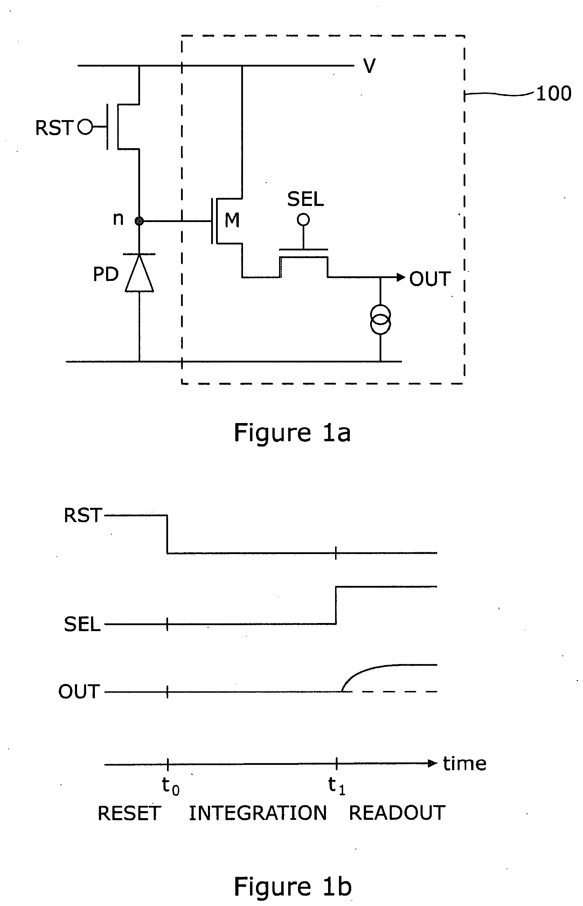

Figure 1a is a circuit diagram of a pixel of a conventional three transistor (3T) type active pixel sensor (APS). Other types of active pixel sensor are known such as 4T. All types of APS include transistors which perform some processing of charge or voltage resulting from photogeneration, or control readout of the charge or voltage. 5T and 6T APS are also known, adding extra functionality.

For the 3T APS shown in figure 1a, the pixel comprises a photodiode PD which is connected to node n. The photodiode is connected such that its cathode is connected to the node. The node is connected to a reset transistor RST and a further transistor M. The reset transistor RST is connected between a voltage rail V and the node n such that its source is connected to the voltage rail and its drain is connected to the node. The reset transistor RST acts as a switch where application of a bias to its gate turns on the transistor RST and the voltage from the voltage rail is supplied to the cathode of the photodiode PD.

Turning on the RST transistor resets the photodiode removing any accumulated charge. After reset is complete, the reset transistor is turned off and the voltage at node n remains at V. The detection phase can now begin. This is often known as the integration period. Incident radiation on the photodiode causes charge to build up across the terminals of the photodiode. This reduces the voltage at node n.

Transistor M is arranged in a source-follower configuration such that the voltage or charge at node n controls the voltage at the output (drain) of transistor M. The source-follower allows the charge/voltage at the node to build up during an integration period without removing the accumulated charge. Transistor M is known as buffer transistor.

In the circuit following the buffer transistor M is found the third transistor of the 3T arrangement. The third transistor is the select transistor SEL used for selecting readout of that pixel. The select transistor is connected as a switch. The buffer transistor M and select transistor together form readout circuitry 100 at the pixel. At the end of the integration period the select transistor is turned on and a voltage controlled by the charge accumulated at node n is output at the node marked OUT in figure 1a. Once the voltage has been readout, the select transistor is turned off and the reset phase begins again. Figure 1b is a timing diagram illustrating the turning on and off of the reset RST and select SEL transistors.

The 3T APS sensor comprises an array of pixels each comprising a photodiode and three transistors. The array may consist of rows and columns of pixels. The gate of the select transistor of a given pixel may be coupled to the gate of the select transistor of all other pixels in a column, such that all pixels in the column are readout at the same time. After readout of one column, other columns may be readout sequentially.

A problem with conventional APS sensors is that the dynamic range of each pixel is limited by the voltage swing available and the intrinsic noise. The voltage swing and noise will be mainly determined by the CMOS technology used, with some influence from the design. For example, typical noise values are of the order of 100-200 µV rms. The limit for the voltage swing is given by the maximum power supply available in that CMOS technology, e.g. 3.3V for a 350 nm process, but more stringent limits are normally set by the design. For example, there has to be an allowance for a threshold voltage Vth drop across the transistors used. Bearing this in mind, typical values for the dynamic range in a 350 nm technology are of the order of a few thousands, rarely achieving 10,000. These values correspond to dynamic ranges of the order of 60 to 80 dB, or a number of bits ranging from 10 to 13. Many applications require a wider dynamic range, such as medical imaging, synchrotron imaging and visible light imaging in the sun and shade for automotive applications.

Attempts have been made to extend the dynamic range using an on pixel storage capacitor. 4T APS sensors include a floating diffusion region between the photodiode and the readout circuitry. The fourth transistor connects the floating diffusion to the photodiode, for example as described in US 6,307,195. US 6,512,544 and US 7,466,003 also disclose the use of a capacitance connected between the photodiode and readout circuitry, but make little provision for the increased noise such a capacitance will add.

EP 1868377 A1 discloses an optical device such as an optical sensor or a solid-state imaging device having a photodiode for receiving light and producing photocharges and a transfer transistor (or an overflow gate) for transferring the photocharge. The optical device is configured that photocharges overflowing from the photodiode in storage operation are stored into a plurality of storage capacitance elements through the transfer transistor or the overflow gate, thereby obtaining the optical device adapted to maintain a high sensitivity and a high S/N ratio and having a wide dynamic range.

### Summary of the Invention

The present invention provides a sensor array as set out in claim 1 and a method of operating the sensor array as set out in claim 9.

There is provided a sensor array comprising an array of pixels, each pixel comprising: a photodiode; a node arranged to develop or accumulate a voltage based on charge accumulated at the photodiode due to photogeneration; and a first overflow unit coupled to the node, the first overflow unit comprising a transistor and a capacitance. The transistor and the capacitance may be known as an overflow transistor and an overflow capacitance. The sensor array being arranged to control the first overflow unit to accept overflow charge from the node into the capacitance of that overflow unit, and to subsequently read the overflow charge stored at the capacitance. The overflow unit provides an advantage of increase dynamic range. The arrangement allows the flow of overflow charge to be controlled by a transistor.

The transistor may be arranged to function as a voltage-controlled resistor during an integration period in which photogenerated charge is collected, and to act as a switch during readout of the charge collected at the capacitance. The functionality of the transistor is set by the bias voltage applied to the gate terminal.

The transistor may be arranged to control charge collection to, and readout of charge from, the capacitance.

Each pixel may further comprise readout circuitry and reset circuitry coupled to the node. Each pixel may be arranged for sequential readout from the photodiode and the first overflow unit.

The photodiode may be coupled to the readout circuitry through the node and the transistor may be arranged such that when it is turned off the photodiode alone is set for readout, and when it is turned on the capacitance, in parallel with the photodiode, is set for readout.

The readout circuitry may comprise a readout select switch for selecting readout from the pixel, and the reset circuitry may comprise a reset switch for resetting the photodiode, and the reset circuitry may be further arranged such that if the transistor of the first overflow unit is turned on the reset switch resets the first capacitance of the first overflow unit. By resetting the capacitance we mean resets the voltage across the capacitance to nominal predetermined levels such as determined by supply voltages, and removing a voltage representative of an accumulated photocharge.

The transistor of the first overflow unit may be arranged to at least partially turn on after the photogenerated voltage at the node exceeds a threshold, namely turn on sub-threshold, to allow charge to flow to the capacitance from the node.

The readout circuitry may comprise an amplifier arranged for readout of a voltage based on the photogenerated voltage at the node.

The transistor of the first overflow unit may be arranged such that at readout: the gain of the amplifier when the transistor is turned off is higher than when the transistor is turned on; and noise when the transistor is turned off is less than when the transistor is turned on.

The transistor of the overflow unit may be arranged such that when the transistor is turned on the first capacitance and photodiode are connected in parallel to the node.

Each pixel of the sensor array further comprises one or more further overflow units arranged in series with the first overflow unit, each further overflow unit comprising a further transistor and a further capacitance, the sensor array arranged to control each overflow unit to accept overflow charge from the previous overflow unit in the series, and to subsequently read said overflow charge stored at each further capacitance. Further overflow units allow more charge to be stored, with adaptively variable amounts of gain.

The further transistor may be arranged to control charge collection to, and readout of charge from, the further capacitance.

Each pixel may be arranged for sequential readout from the photodiode, the first overflow unit, and each further overflow unit.

The further transistor may be arranged such that when the further transistor is turned off the photodiode and/or first capacitance are set for readout, and when the further transistor is turned on the further capacitance is set for readout. The further capacitance may be set for readout in parallel with capacitances of other overflow units earlier in the series and with the photodiode. When the further transistor is turned on for readout of the further capacitance, the transistors of the first and any other overflow units in the series may also be turned on.

The further transistor of the further overflow unit may be arranged to turn on after the voltage across the capacitance of the previous overflow unit in the series has exceeded a threshold.

The further transistor of the overflow unit may be arranged such that when the further transistor is turned on the further capacitance and capacitance of the first overflow unit are connected in parallel.

Each further capacitance of each further overflow unit may have a greater value than the capacitance of the previous overflow unit in the series.

The sensor array further comprise a decision block arranged to select readout of one of the photodiode, first overflow unit, or any further overflow units, based on the significance level of the stored charge in each of the photodiode, first overflow unit, and any further overflow units.

The sensor array may further comprise at each pixel an anti-blooming switch coupled to the first overflow unit if only one overflow unit present, or coupled to the last overflow unit in the series if a plurality of overflow units are present, the anti-blooming switch arranged to turn on when the stored charge at all of the photodiode, first overflow unit and any further overflow units exceeds a maximum or threshold stored charge. The anti-blooming switch may be coupled to a voltage for receiving any charge in excess of the maximum stored charge.

Each pixel may comprise a snapshot unit, the snapshot unit may be arranged to be triggered simultaneously with snapshot units of all other pixels to record an accumulated charge at a trigger time, the snapshot unit storing a charge representative of the charge accumulated on the photodiode and the charge accumulated on the first overflow unit. The snapshot unit may comprise a first element for storing the charge accumulated at the photodiode and a second element for storing the charge accumulated at the first overflow unit, each element comprising a snapshot switch and capacitance. The snapshot unit may comprise transfer switches for transferring the charge stored at the photodiode and first overflow to the first and second elements, and transfer switches for reading out the charge stored at the first and second elements.

The sensor array may further comprise further overflow units, wherein the number of elements of a snapshot unit is one more than the number of overflow units.

There is further provided a method of operating the sensor array set out above, the method comprising: resetting pixels of the array by turning on a reset switch and transistor of the first overflow unit to supply a predetermined voltage across the photodiode and the capacitance of the first overflow unit; when reset is complete, turning off the reset switch and transistor of the first overflow unit; accumulating photogenerated charge at the photodiode; the transistor of the first overflow unit turning on sub-threshold when the photogenerated charge overflows from the photodiode; accumulating overflow charge at the first overflow unit, wherein the charge accumulation continues until an integration period is complete; and after the integration period is complete sequentially reading out the stored charge from the photodiode and first overflow unit.

The step of sequentially reading out the stored charge from the photodiode and first overflow unit, may comprise: turning off the transistor of the first overflow unit; reading out a voltage at the node representative of the charged stored at the photodiode; turning on the transistor of the first overflow unit and reading out a voltage at the node representative of the stored charge from the first overflow unit.

The sensor array further comprises one or more further overflow units arranged in series with the first overflow unit, and the method may further comprise: in the step of resetting turning on transistors of the further overflow units to supply the predetermined voltage across the capacitance of the further overflow units; when reset is complete, turning off the transistors of the further overflow units; accumulating photogenerated charge at the photodiode; the transistor of each further overflow unit turning on sub-threshold when charge overflows from the previous overflow unit in the series; accumulating further overflow charge at the capacitance of the further overflow units, wherein the charge accumulation continues until the integration period is complete; and after the integration period is complete sequentially reading out a voltage representative of the stored charge from the photodiode, first overflow unit, and any subsequent overflow units.

The step of sequentially reading out the stored charge from the photodiode, first overflow unit, and any subsequent overflow units, may comprise: turning off the transistors of the overflow units; reading out a voltage at the node representative of the charge stored at the photodiode; turning on the transistor of the first overflow unit and reading out a voltage at the node representative of the stored charge from the first overflow unit; and sequentially turning on the transistor of each further overflow unit, in combination with the previous ones in the series, and reading out a voltage representative of the stored charge from each further overflow unit.

### Brief description of the Drawings

Embodiments of the present invention, examples outside the scope of the present invention but provided for information, along with aspects of the prior art, will now be described with reference to the accompanying drawings, of which:
figures 1a and 1b are respectively a circuit diagram and a timing diagram of a 3T active pixel sensor of the prior art;
figures 2a and 2b are schematic cross-sectional views showing the epitaxy for CMOS sensors, with a non-pinned diode and a pinned diode respectively;
figures 3a and 3b are respectively a circuit diagram and a timing diagram of an active pixel sensor having a first overflow unit;
figures 4a-4e show charge and voltage accumulation at parts of the circuit of figure 3a during integration, readout and reset;
figures 5a and 5b are graphs showing voltage and current variation with time for the active pixel sensor of figures 3 and 4;
figure 6 is a circuit diagram of an active pixel sensor having three overflow units;
figure 7 is a timing diagram of the active pixel sensor of figure 6;
figure 8 is a timing diagram for a simulated pixel in 5V CMOS using NMOS overflow transistors;
figures 9 to 13 are graphs illustrating the output voltage for each of the four phases of readout as a function of stored charge for the active pixel sensor of figures 6 and 8;
figure 14 is a schematic figure of a decision block according to an embodiment of the present invention, for the example active pixel sensor of figure 6;
figure 15 is a circuit diagram of an active pixel sensor having an overflow unit and anti-blooming circuitry; and
figure 16 is a circuit diagram of an active pixel sensor having an overflow unit, anti-blooming circuitry and a snapshot shutter.

### Detailed Description

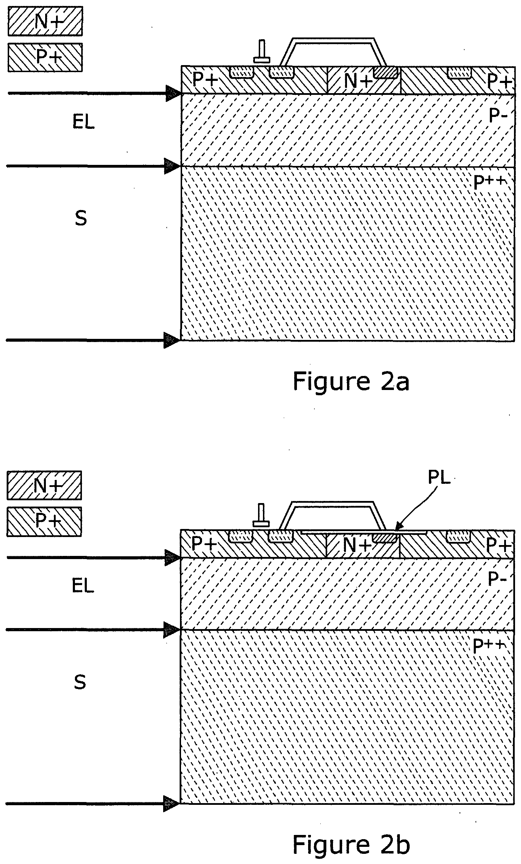

APS sensors are typically fabricated using CMOS technology. A cross section of the processed structure is shown in figure 2a. Typically CMOS image sensors are made on an epitaxial substrate. These substrates have a thin epitaxial layer (EL in figure 2a), relatively lowly doped, grown on top of a thick, highly doped substrate (S in figure 2a), whose main provision is to provide mechanical stability to the silicon wafer. In the planar technology typical of microelectronics processes, devices are generated on the top surface by a succession of steps including implants, diffusion, etc. Typical CMOS substrates are of P-type, hence the sensing diode needs an N-implant in order to create a P-N junction to the epitaxial layer. The epitaxial layer will then act as the sensing volume and charge generated in it by radiation will be collected by the sensing diodes to eventually generate an image. The diode can be made by using standard available N-implants, like an N-well, or dedicated N implants, the latter choice being the one normally applied in modern CMOS image sensors. The diode can also be pinned or partially pinned, as shown in figure 2b. In a pinned diode, a shallow P-implant covers the diode. In figure 2b the shallow implant is indicated by pinning layer, PL. This P-implant was first introduced in "An interline CCD image sensor with reduced image lag", Teranishi, N.; Kohno, A.; Ishihara, Y.; Oda, E.; Arai, K., IEEE Transactions on Electron Devices, Volume: 31, Issue: 12 and its function is to reduce the leakage current. Such a diode is used in 4T pixels. In a partially pinned diode, the pinning layer does not cover the entire surface of the sensor. It typically leaves a small area uncovered, and contacts are being placed in this area. The pinned part of the diode has the benefit of having low leakage current as well as zero capacitance and it is thus particularly suitable to make a large diode with good performance. The pinning layer should also make the diode more resistant to radiation damage. This can be explained as follows. Radiation creates electron-ion pairs in the silicon dioxide layer over the silicon surface. Electrons have a relatively large mobility and are swept away by an electric field, while ions are left in the oxide. This oxide becomes then positively charged attracting electrons at the silicon-silicon dioxide interface. These electrons can be a source of surface leakage current. As a pinned diode has an excess of holes at the surface, these holes recombine with the electrons attracted by the positive oxide fixed charge, thus eliminating the surface leakage current and making the diode more resistant to radiation damage.

Transistors are normally made in wells, with NMOS transistors in P-well and PMOS transistors in N-well. In figures 2a and 2b, only an NMOS transistor is shown. This is typical in image sensors as the addition of the N-well of PMOS transistors would create competition in charge collection, unless a special layer is added as described in WO2004/099740.

It is also worth noting that the thick lowly doped substrate could be removed by backthinning to allow for back-illumination. Once removed the substrate needs to be annealed in order to avoid the defects created by the backthinning process to generate traps that would negatively affect the charge collection. Annealing can be done by one of the several techniques available, including laser annealing or delta-doping.

In CMOS technology there are scaling laws that set the main parameters of transistors. For example, in a 350 nm technology, the minimum gate length and width would be 350 nm or very close to it. The gate oxide thickness would be about 7 nm and this would set a maximum operating voltage at 3.3 V, given the standard breakdown voltage of silicon dioxide at 1V/nm and a good safety margin to allow for reliable operation of multimillion or billion transistor devices. When moving to a different technology node, geometrical dimensions roughly scale linearly as well as voltages, so that a 180 nm technology would operate over a voltage range of 1.8V and have an oxide thickness of about 4 nm.

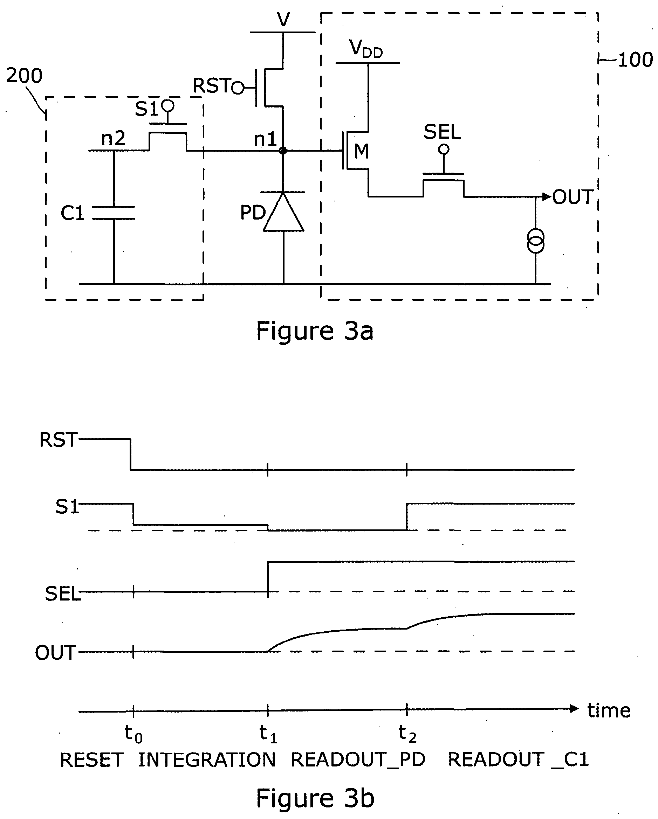

Figure 3a is a circuit diagram of a pixel of a sensor array according to an example outside the scope of the present invention but provided for information. The pixel of the sensor array comprises a photodiode PD, a reset transistor RST, buffer transistor M, and a select transistor SEL. Each of these features acts in the same manner as the conventional 3T APS sensor of figure 1, except that the supply rails for transistors RST and M are separate so as to allow different voltages to be used. Again, buffer transistor M, and a select transistor SEL form readout circuitry 100. The reset transistor RST, photodiode PD and buffer transistor M are connected to a node n1. The node n1 is similar to the node n of figure 1 except that the node n1 also has connected to an additional transistor S1 which we may call overflow transistor. There is connected a capacitor C1 in parallel with the photodiode PD. We may call the capacitor C1 an overflow capacitor. The transistor S1 couples the cathode of the photodiode PD to the capacitor C1. Preferably, the capacitor C1 has a capacitance larger than that of the photodiode PD. The capacitor C1 and photodiode PD together form an overflow unit 200. Node n2 is formed at the connection between the transistor S1 and capacitor C1 of the overflow unit 200.

The capacitance can be made in different ways. In many CMOS technologies, linear capacitors are provided and they are made by a thin dielectric, insulating layer, sandwiched between two conductors, i.e. polysilicon or metal. These capacitors have good linearity but the capacitance density might be smaller than other less linear components, e.g. the MOS capacitor created by the transistor gate. These latter can provide higher circuitry density which can be beneficial in many applications as it means a larger number of pixels can be integrated in a smaller area. If the latter approach is considered, it should also be evident that the transistors used as overflow capacitors can be of a different type from the transistors used in other parts of the pixel. For example, the overflow capacitors can be made with transistors with the thinnest available oxide to maximise their density while other transistors, e.g. the buffer transistor, can be made from a thicker oxide as it would maximise the voltage swing hence the dynamic range. If this mixed approach is chosen, some care has to be given to the operating voltages in order not to exceed safe limits of operation.

We will now describe operation of the pixel. Figure 3b is a timing diagram showing operation of transistors and the output of the pixel. Pixel operation is usually considered to begin and end at reset and this is where we shall begin. The reset phase commences by turning on the reset transistor RST and transistor S1 of the overflow unit 200. This supplies the voltage V from the reset rail to node n1 such that it is supplied across the photodiode PD. Since S1 is also turned on the voltage V is also applied across capacitance C1. Above we mentioned that the supply rail voltages connected to (the source) of the RST and M transistors may be different, as indicated in figure 3a by V and VDD. This is often not done in conventional imagers because of space limitations, but it is important in this case because it allows us to operate the buffer transistor M at a higher voltage than the reset voltage V. This means that we can use denser 1.8V transistors as capacitors, while keeping the 3.3V for readout and switching. This helps with dynamic range.

The voltage on the reset rail will be determined by the need for a soft or hard reset as well as by the maximum operating voltage of the transistors affected by this voltage. For example, if one only considers the readout part 100 and the RST transistor with the diode, hard reset would demand RST voltage to be in excess of one Vth greater than the voltage at the gate of RST to take into account the transistor threshold voltage. If one considers the overflow units, if capacitor-mounted transistors are used for C1, they might determine the maximum reset voltage that can be applied for it. For example, if maximum density is required, C1 could be made of a 180 nm transistor in a dual voltage process. In this case the reset voltage should not exceed the voltage of 1.8V plus 10%, i.e. about 2V. With this voltage is also possible to hard reset the diode through a 3.3V reset transistor without having to overdrive the gate of the reset transistor. After reset the transistor RST is turned off. The transistor S1 is also turned off, but preferably by using an intermediate voltage Vmid, e.g. a voltage higher than 0 V for an NMOS. This arrangement is important for the correct operation of the overflow as described later.

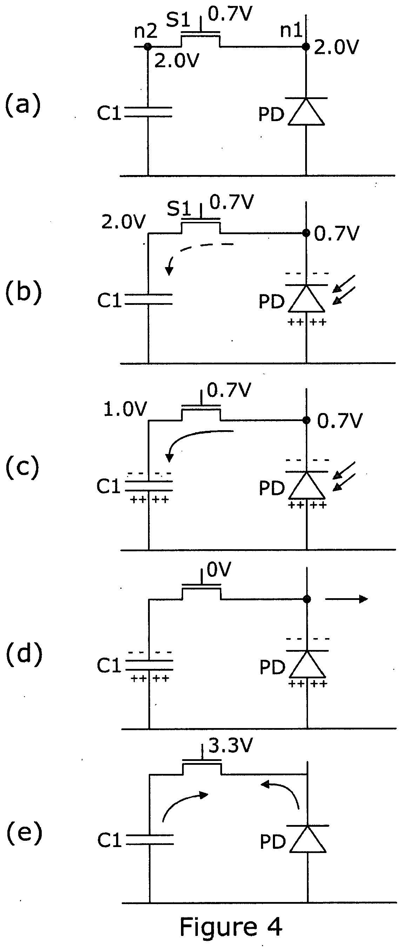

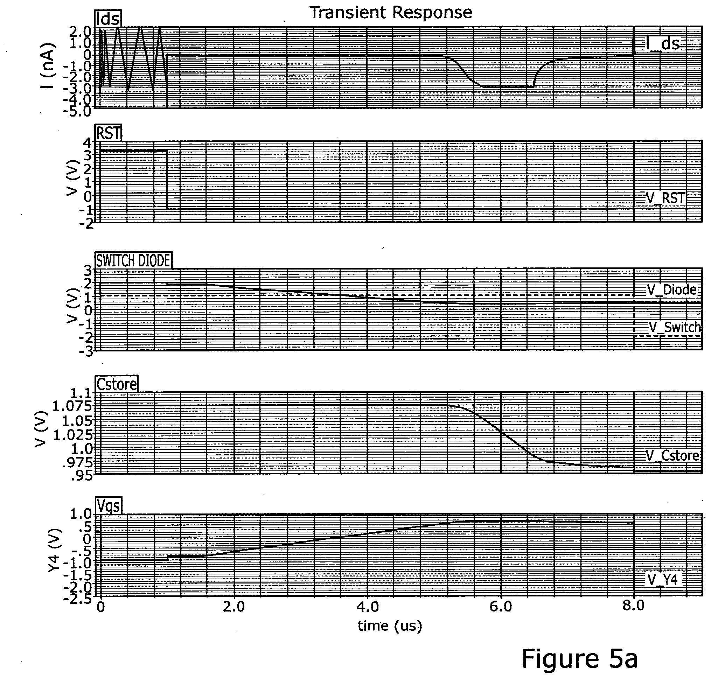

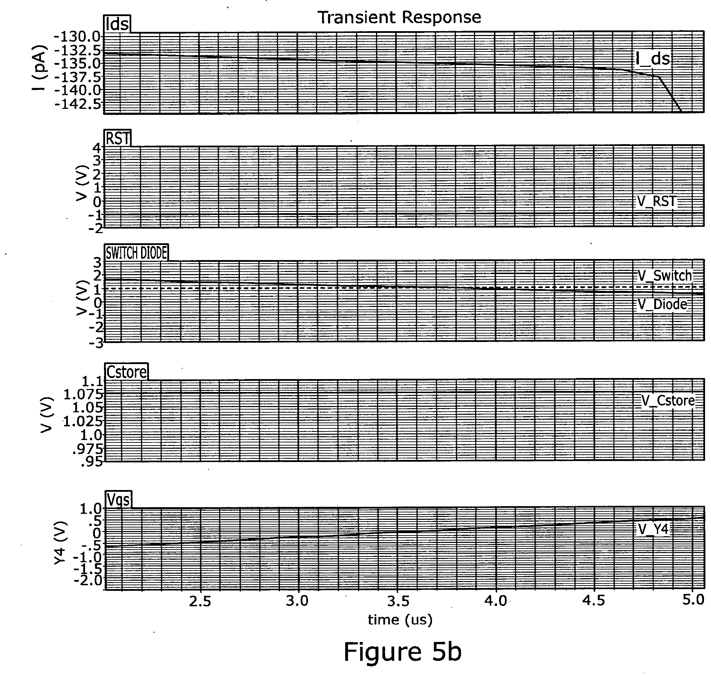

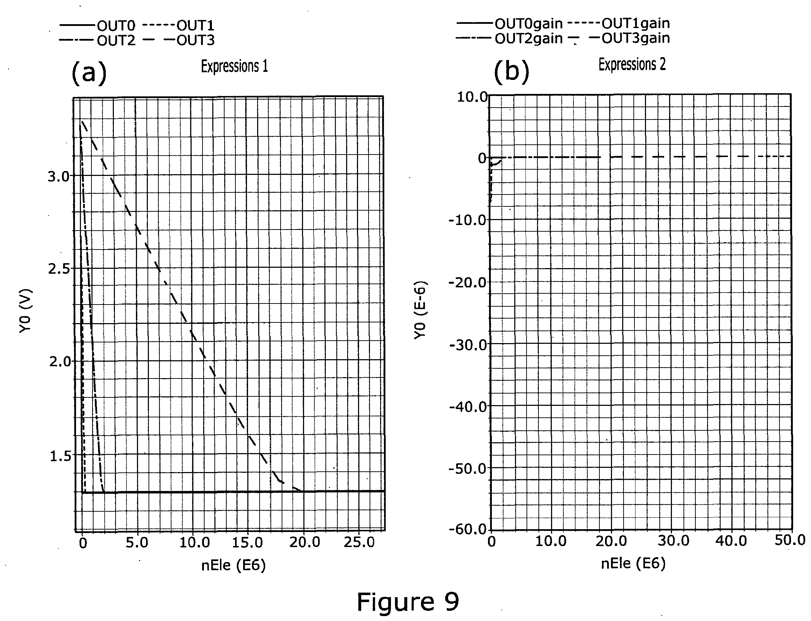

Figure 4 shows the charge and voltages at the photodiode PD, node n1, and overflow unit 200 at various times throughout reset, integration and readout. As shown in figure 4a, after reset the nodes n1 and n2 are both set to the voltage supplied from the voltage rail V, for example 2.0V. After reset, the integration period begins and light or other electromagnetic radiation incident on the photodiode causes charge to accumulate across the photodiode PD. As charge accumulates across the photodiode, this reduces the voltage at node n1. In a preferred example the transistor S1 of overflow unit 200 is an NMOS transistor such that it turns on when the gate-source voltage goes positive. As explained above at the start of the integration phase the gate is set to a voltage Vmid less than that at the node n1. For example, the gate voltage may be set to 0.7V such that the gate-source voltage is -1.3V (=0.7-2.0V). To understand the operation of transistor S1 it is useful to identify its source and drain. As voltage at node n1 reduces, node n1 becomes less positive than n2, hence becoming the source of the transistor. So the Vgs voltage for S1 is given by Vmid-V(nl). Note that Vgs is initially negative and it increases as V(n1) decreases. As it approaches zero, transistor S1 starts entering sub-threshold operation, so that a small current starts to flow through it. As this current is small the diode will continue to discharge at a rate depending on the amount of illumination and transistor S1 could even enter strong inversion operation if the Vmid voltage is too high. Vmid should be kept as small as possible as its value determines the knee point for the transfer curve as explained below in relation to figures 5a and 5b. As S1 slowly turns on, charge will start accumulating on C1. Depending on the integration time and on the photocurrent, eventually n1 and n2 could reach the same value. Full turn-on would result in a flow of charge from the photodiode to the capacitor to equalise the voltages at nodes n1 and n2. The sub-threshold turn on maintains the voltage at node n1 at, for example, 0.7V and any extra photogenerated charge flows to the capacitor C1 of the overflow unit as shown in figure 4b. Photogenerated charge continues to flow to the capacitor C1 until the end of the integration phase at time t1 in figure 3b. Figure 4c shows that photogenerated charge accumulated on the diode generated a voltage of 1.3V there and the amount of photogenerated charge accumulated on the capacitor generated a voltage of 1.0V there. The exact relationship between charge and voltage can be obtained by calibration, which would generate curves similar to the ones showed in figures 9 to 13.

In the readout phase, the goal is to separately read 1) the voltage corresponding to the charge accumulated on the diode and 2) the voltage corresponding to the charge accumulated on the diode and the capacitor C1 in parallel. In order to minimise contamination from capacitor C1 for the first reading and in the case the sensor is used for the detection of light pulses occurring at known instants, transistor S1 can be turned totally off by applying a zero, or even negative voltage. Once the transistor S1 is off, the readout phase can begin by turning on the select transistor SEL of the readout circuitry. Thus, through the buffer transistor M, the voltage at node n1 is readout. In the case of figure 4, a voltage of 0.7 V will be readout through the buffer transistor. Next the charge stored in the overflow circuitry must be readout. The transistor S1 of overflow circuitry is turned fully on by setting the gate voltage high, for example to 3.3V, as shown in figure 4e. The charge stored on the capacitor and photodiode flows to equalise the voltage at nodes n1 and n2, and again the voltage at n1 is readout.

Further details of how the pixel works are illustrated in figures 5a and 5b. The signals shown in the figures are:
- I_ds corresponding to the current flowing through the transistor in the overflow unit;
- V_RST corresponding to the voltage applied to the gate of RST in figure 3a;
- V_SWITCH corresponding to the voltage applied to the gate of transistor S1 in figure 3a;
- V_DIODE corresponding to the voltage at node n1 in figure 3a;
- V_Cstore, corresponding to the voltage at node n2 in figure 3a; and
- V_Y4 = V_SWITCH-V_DIODE, i.e. Vgs of transistor S1 in the overflow unit.
The initial phase is the reset phase. During this phase V_SWITCH is held at 1V in this simulation (compared to 0.7V in figure 4) but the absolute value is not really important. What matters is the comparison with the other levels. Ids is very small at the beginning and the large fluctuations up to 1 µs are due to numerical errors and not relevant for the physical understanding of the device. After the reset, the charge starts to flow into the diode, lowering its potential. V_Y4 (i.e. Vgs of S1), is initially negative which means that the transistor in the overflow unit is totally off. This voltage gradually increases to become positive. In figure 5a it is not appreciable, but in figure 5b one can see that the current Ids is slowly increasing. When growing through sub-threshold, 0<Vgs<Vth∼0.7V in this device, and getting closer to Vth, the current is more rapidly increasing, until the transistor reaches saturation, i.e. Vgs > Vth, after which the current is relatively high and constant, being relatively unaffected by Vds=V_Cstore-V_DIODE. A relatively high current also means charge is starting flowing from the photodiode (V_DIODE) to the overflow capacitor (V_Cstore). V_Cstore drops rapidly initially but then when Vds=V_CStore-V_DIODE becomes smaller than or closer to Vgs-Vth, the transistor goes back into linear region with a much smaller current. Also shown in the figure is that if the voltage applied to the gate of S1 (V_SWITCH in figures 5a and 5b) is lowered (in this case even negative). The flow of charge is stopped as the transistor in the overflow unit is made totally off again.

Buffer transistor M together with a current source common to all pixels in a column provide a buffer from the in-pixel capacitance, diode and/or additional capacitor C1, and can also provide gain to the output signal readout when the select transistor is turned on. As a source follower the gain of the buffer will be nearly or smaller than 1. The charge-to-voltage conversion gain is also influenced by the input capacitance at the buffer transistor M, being inversely proportional to the input capacitance. During the first readout phase, the transistor S1 is off so the input capacitance is given by the capacitance of the photodiode PD in parallel with the overlap capacitances of the reset and S1 transistors. All these capacitances can be fairly small so that the gain is high. A high conversion gain implies a small overall noise as: 1) the kTC noise is smaller; and 2) if correlated double sampling (CDS) is applied to eliminate the reset noise, the influence of the readout noise is small as its conversion in electrons happens by dividing it by the charge-to-voltage conversion gain GC ∝ 1/C. A small capacitance also means a small full well as FW = ΔV/GC ∝ C, where ΔV is the voltage swing.

During the second readout phase the transistor S1 of the overflow unit is turned fully on, such that the input capacitance to the buffer transistor is connected in parallel to the capacitance of capacitor C1. Often the capacitance of C1 will be much larger than that of the photodiode so that significantly more charge can be stored, but the exact value can be tailored according to the application. The total capacitance Ctot will have several effects. First a higher value of the capacitance means a smaller conversion gain. Secondly, the full well will be proportionally increased as explained above. Last, the input referred noise, i.e. the noise in electrons rms, will increase, with the exact value depending on whether the sensor is read in correlated double sampling or not. While it is always desirable to have a low noise readout, as the signal increases, so does the shot noise associated with the source. The photon shot noise power is proportional to the number of photons which generated the signals. For visible light and in general for light of wavelength longer than 400 nm, each absorbed photon generates one electron-hole pair in silicon, but this number increases with decreasing wavelength below 400 nm. Whatever the energy of the radiation, large signals bear a larger photon shot noise so that the influence of the intrinsic noise is less important. In general, when switching from the diode signal to the combined diode-capacitance signal, there would be a loss in signal-over-noise ratio due to the increased intrinsic noise. However, the parameters of the sensor, e.g. capacitance at the nodes n1 and n2 can be defined in such a way to minimise this loss and optimise the detection for the specific application

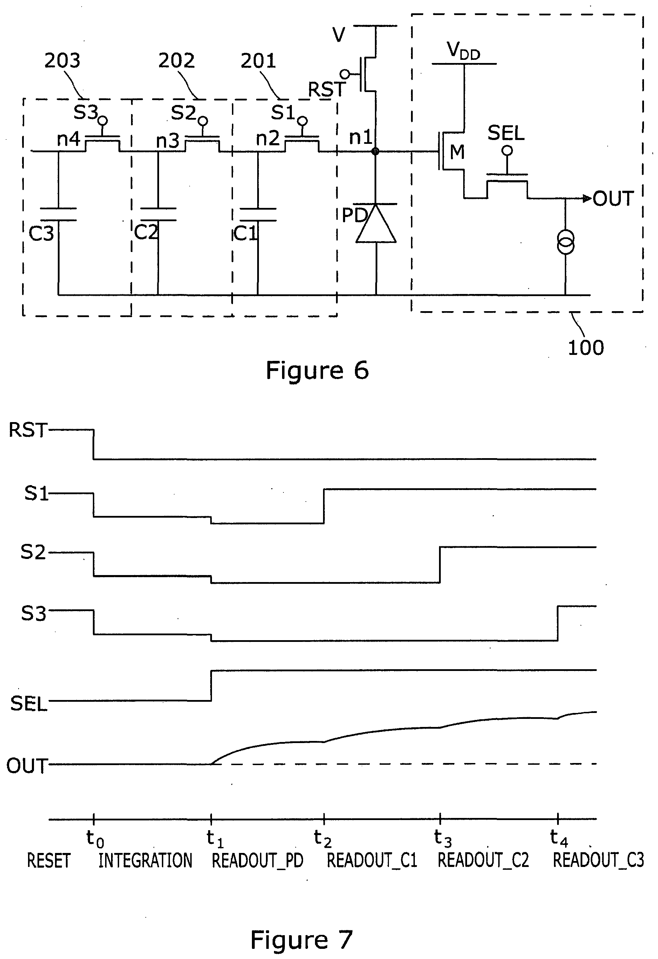

The circuit of figure 3a can be extended to include a plurality of overflow units to further extend the dynamic range and photogenerated charge that can be stored. Figure 6 is a circuit diagram of an example outside the scope of the present invention comprising three overflow units 201, 202, 203. Each overflow unit is the same as the overflow unit 200 of figure 3a and is connected in series with the next. The first overflow unit 201 is connected to node n1 in the same way as overflow unit 200 of figure 3a. Node n2 between capacitor C1 and switch S1 of first overflow unit 201 is used as the connection point for the second overflow unit 202. Second and third overflow units respectively comprise second capacitor C2 and second transistor S2, and third capacitor C3 and third transistor S3. Between transistors S2 and S3 is a third node n3. Between transistor S3 and capacitor C3 of third overflow unit is fourth node n4. Preferably, each overflow unit further from photodiode PD has an increased capacitance over the previous one. For example, each capacitor may be 5 times greater than the previous to produce an almost exponential increase in charge storage capacity. For example, the ratios of charge storage capacity may be
PD: C1: C2: C3 = 1: 5: 25: 125.
Other ratios could be used. The ratio change between a capacitor and the first overflow capacitor, or between successive overflow capacitors, could differ from one to another, rather than being fixed at for example, five as in the above example. Similarly to what happens in the example with one overflow capacitor, the exact value of the capacitors affect the dynamic range loss at the knee points and it can be optimised for a specific application.

The operation of the active pixel sensor circuit of figure 6 is illustrated by the timing diagram of figure 7, and is similar to the operation of the circuit of figure 3a.

The sensing cycle begins with the reset phase in which the transistors S1, S2 and S3 of the overflow units are turned on. The turn on is achieved by applying a high signal, such as 2.0 or 3.0 V to the gate of each transistor. At the same time the reset transistor RST is turned on and the voltage V from the reset supply rail is applied across the photodiode PD and capacitances C1, C2 and C3 to remove accumulated charge across the photodiode and each of the capacitors. During the reset phase the select transistor SEL of the readout circuitry 100 is off.

After the reset phase follows the integration period during which light or other radiation incident on the photodiode generates charge. At the start of the integration period the reset transistor RST is turned off and the voltage V applied from the supply rail remains at each of the nodes n1, n2, n3 and n4. For example, each node is set to 2.0V. As discussed above in relation to the example of figure 3a the gate voltage on the transistors S1, S2 and S3 of the overflow units controls the point at which the transistors allow small amounts of current to flow. As discussed above this is determined by Vgs. As Vgs approaches zero, the transistor begins to operate sub-threshold allowing the small current to flow. The same voltage Vmid is preferably applied to the gate of all three transistors. Again the transistor will operate in sub-threshold. In a preferred example the gate voltage is set to 0.7V.

Radiation incident on the photodiode causes charge to be generated and accumulates at cathode and anode of the photodiode PD. The accumulated charge reduces the voltage at node n1. If the radiation causes the generated charge to increase the voltage at node n1 such that the gate-source voltage (Vgs) becomes positive the transistor will turn on sub-threshold. For the example voltage given above, the photogenerated charge will need to increase the voltage at node n1 by 1.3 V from 2.0V to 0.7V.

As mentioned above, when the transistor S1 of the first overflow unit 201 turns on, it turns on sub-threshold such that excess charge at the node n1 flows to node n2 and is stored by the capacitance C1 of the first overflow unit. This is identical to the embodiment of figure 3a.

As charge continues to be generated and stored in the first overflow unit, the voltage on node n2 will decrease from its preset value. The rate at which the voltage increases will depend on the size of the capacitance C1. The voltage at node n2 will at some point, assuming sufficient photogenerated charge, be reduced such that again the gate-source voltage for the transistor S2 of the second overflow unit also goes positive. In this example we have assumed node n2 was initially set to 2.0 V and the gate voltage was set at 0.7 V. As for the case of the photodiode PD and first overflow unit a decrease in the node voltage by 1.3 V from 2.0 V to 0.7 V is needed for turn-on. However, the amount of charge stored may differ significantly between turn on of first overflow unit and turn-on of second overflow unit. The charge stored before turn on of the first overflow unit will be determined by the charge that can be stored on the photodiode PD, which will largely be determined by its capacitance. The charge that can be stored by the first overflow unit will also be determined by its capacitance, but the capacitance of C1 will be larger than that of the photodiode allowing more charge to be stored. For example, the capacitance C1 may be a factor of 2, 5 or 10 times larger than that of the photodiode PD.

When the transistor S2 turns on (sub-threshold), the first overflow unit may be considered to be full and extra generated charge will flow to capacitance C2 of the second overflow unit in a similar way to charge overflowing from the photodiode PD when the first overflow unit turned on (also sub-threshold).

Overflow charge will continue to flow to second overflow unit 202 until the second capacitor C2 becomes full. C2 will become full when the voltage at node n3 has been reduced from its preset voltage such that the gate-source voltage (Vgs) goes positive. The preset gate voltage and voltage at node n3 determine the point at which this happens. The second capacitance C2 may be a different size to the first capacitance C1, and is preferably larger than the first capacitance such that a relatively greater amount of charge than for C1 may be stored on C2. Preferably C2 is 2, 5 or 10 times larger than C1.

When the gate-source voltage (Vgs) at the third transistor S3 of the third overflow unit goes positive, the third transistor turns on sub-threshold such that charge overflowing from the photodiode now flows to the third overflow unit.

Although figure 6 shows active pixel circuitry with three overflow units, any number of overflow units could be included. The limit of the number of overflow units will be a trade-off with the pixel area available for the light collection part of the pixel (fill factor).

As mentioned above figure 7 is a timing diagram of the pixel. After the integration period has been completed readout of the pixel commences. Conventionally CMOS APS sensors comprising an array of pixels are readout a row at a time with all pixels in that row providing an output signal along separate output lines at the same time. In the present example each pixel has charge stored at some or all of the photodiode PD and first to third overflow units 201, 202, 203.

Readout commences with transistors S1, S2 and S3 of all overflow units 201, 202, 203 fully off, with zero or negative voltage limiting any charge flow such that they can be considered to be turned off. This corresponds to figure 4d of our earlier examples. As shown between times t1 and t2 in figure 7, the select transistor SEL is turned on such that the voltage at node n1 is readout. The voltage readout is effectively a measure of the charge stored across photodiode PD. As described in relation to figure 3a the voltage is readout through buffer transistor M which acts as an amplifier. After readout of the photodiode PD, readout of the first overflow unit begins. Transistor S1 of first overflow unit is turned fully on and charge flows from node n2 to equalise the voltage at node n1. Full turn on of transistor S1 is achieved by applying 3.3V to the gate of the transistor S1. The increased voltage at node n1 is readout. Sequentially the switches of each of the successive overflow units are turned fully on and the increased voltage at node n1 is readout. The select transistor SEL of readout circuitry 100 remains on throughout this readout process.

The readout timing is shown in figure 7. In more detail, the readout phase starts by activating the transistor SEL by applying a high voltage on SEL. At this moment, the transistor M is connected to the readout line and acts as a source follower, buffering the voltage stored on the diode PD. This voltage can be stored in a capacitor at the bottom of the pixel array for later processing or directly converted into a digital value. Once it is read, the first switch S1 is activated. With this action PD, whose impedance can be represented as a capacitor, and C1, are connected in parallel and charge is shared between the two. The voltage on n1=n2 is then read through the source follower and can be again stored on a capacitor or directly converted. The same operations are also done on S2 and S3. Each time the charge is shared on an increasingly larger capacitance. This means that the charge-to-voltage conversion gain for the 4 readings is increasingly smaller. As the collected charge is negative (electrons are collected), the same amount of charge is generating an increasingly higher voltage. For reconstructing the charge, one could use the 4 readings, but similar results could be obtained by reading only the smallest voltage, or at least a voltage which is the smallest, although higher than the voltage corresponding to the saturation of the diode.

An advantage of the circuitry of figure 7 is that the capacitance for charge storage can be increased to meet the demands of the photogenerated charge. Having a single high capacitance photodiode or large capacitor would mean that readout noise would be high and gain would be low. In the present arranagments during the first readout phase only the charge stored at the photodiode is readout and the gain of the readout circuitry is determined by the capacitance of the photodiode which is small. Gain is inversely proportional to capacitance. As a result for the readout of the smallest charge, namely that stored at the photodiode, the gain is largest. The noise at readout is also related to the capacitance and is conveniently at its lowest level for readout of the smallest signal.

As each of the overflow units is turned on for readout the buffer transistor is correspondingly connected to larger capacitances, thereby reducing the gain and increasing the noise floor. However, the signal is increasing as shown in figure 7 so the increased noise and reduced gain is not a problem at the larger signal levels. Also photon shot noise is increasing with the signal so that the intrinsic noise is becoming less and less important.

Another advantage of this scheme is that the circuit is relatively insensitive to the variation in technology parameters, e.g. variation of Vth between transistors. The voltage required for V_SWITCH is a voltage that is constant across the array, while Vth varies and so does the voltage where the overflow transistor starts to conduct. However, this is only going to affect the knee point, i.e. the point where it is better to read one or the other values. For most applications, this is not critical, as it only affects the amount of noise added to the measurement, not the linearity of the measurement.

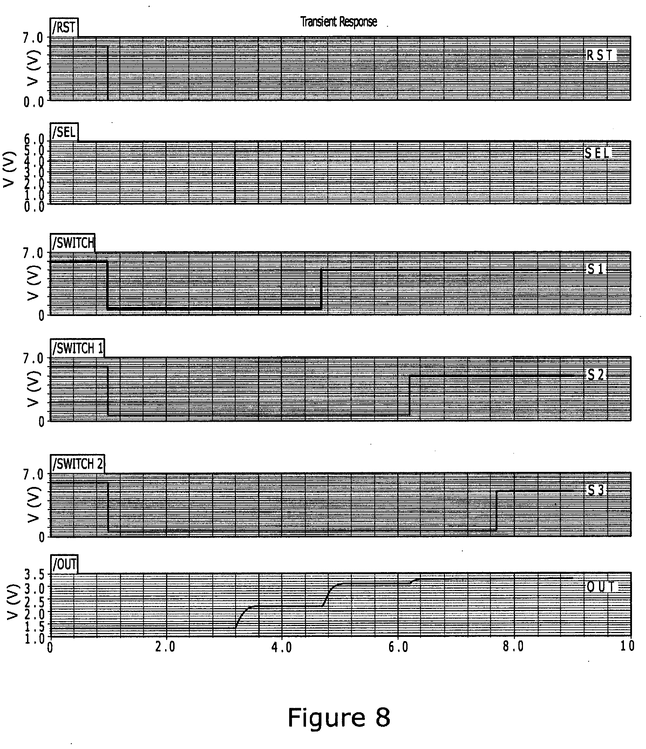

Figure 8 is a timing diagram for a simulated pixel in 5V CMOS using NMOS overflow transistors. The simulation is similar to the timing diagram of figure 7. The exact value of the photodiode and of the overflow capacitances are not important, but it is important to mention that in this simulation the photodiode was not saturated by the radiation. So in this case, the reading of the diode should have been retained as the best evaluation of the charge as this reading had the least amount of noise. In figure 8, up until 1.0µs has elapsed the reset phase is in operation with the reset transistor RST and overflow transistors turned on. In this simulated example the voltages are greater than described above in relation to figures 6 and 7 because the embodiments of figures 6 and 7 assume 5V CMOS which are overdriven to 7.0 V in the simulation. This is only in order to obtaining a hard reset of the diode. At 1.0µs the integration period begins and the transistors RST, S1, S2 and S3 are all turned off. In more detail, RST is turned fully off at 0 V and overflow transistor are set at 0.7 V.

In the simulation charge is generated at photodiode at 1.5µs, namely 0.5µs in to the integration period. The charge is generated in 10 ns.

The various readout phases can be seen in figure 8. The first readout phase, which is readout of the photodiode, occurs at 3.2µs and the output voltage rises around 0.9V. The second readout phase begins at 4.7µs and the output voltage rises by another 0.9V. This is readout of the first overflow unit. The third readout phase commences at 6.2µs and the output voltage rises by a further 0.2V. This third readout phase is that of the second overflow unit. The fourth and final readout phase is readout of the third overflow unit and begins at 7.7µs. For the fourth readout phase the output voltage rises by 0.1V.

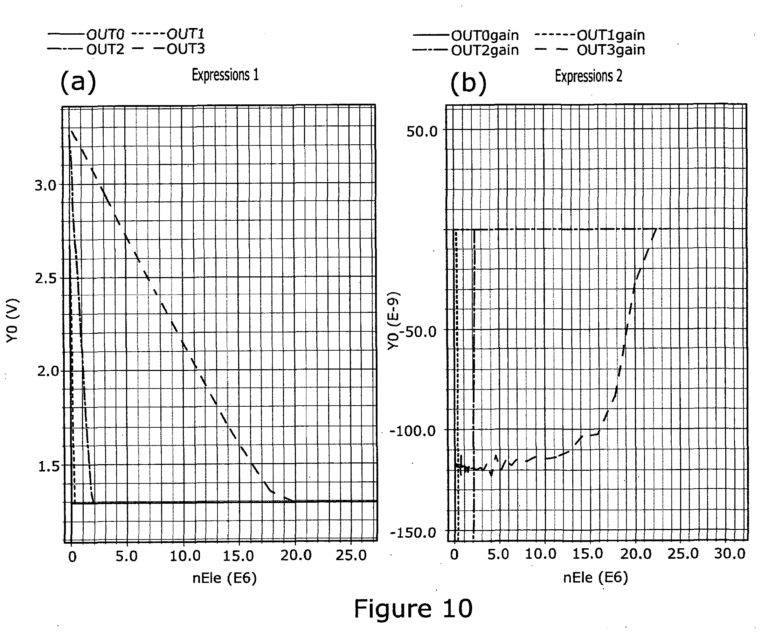

Figures 9 to 13 are graphs illustrating the output voltage (figures a) for each of the four phases of readout as a function of stored charge, as well as the derivative of these curves (figures b), i.e. the gain of the pixel. For each of figures 9 to 13, the ordinate is related to the number of electrons. In figures (a) the ordinate is a linear scale and in figures (b) is a logarithmic scale. Figure 9 shows all of the four output signals, but the scales of the graph make reading of all but the final readout phase difficult to distinguish. Figure 9 shows that with the smallest gain, a full well of over 15 million electrons is achieved. Figure 10 is an expanded version of figure 9, expanded to show the gain of the fourth and final output phase. The gain is lowest for this readout phase at approximately 120nV/e. The gain is relatively constant up to over 10 million electrons, indicating good linearity of the pixel.

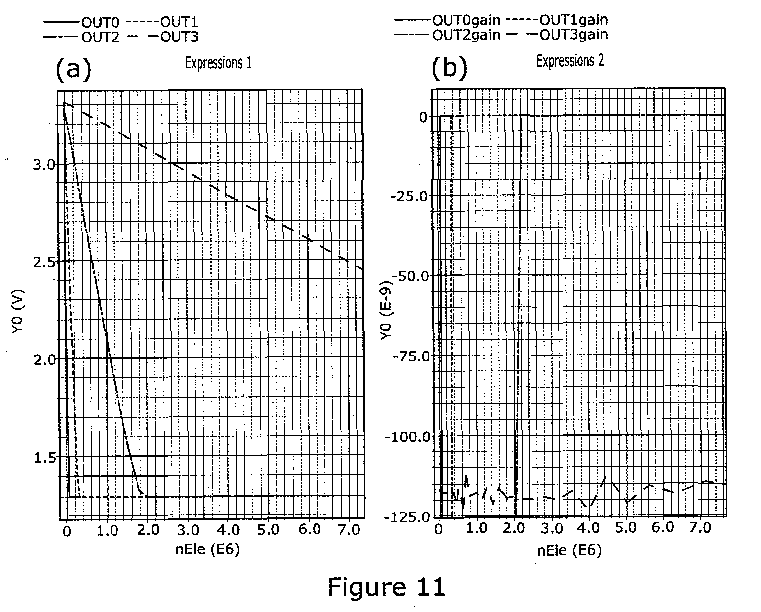

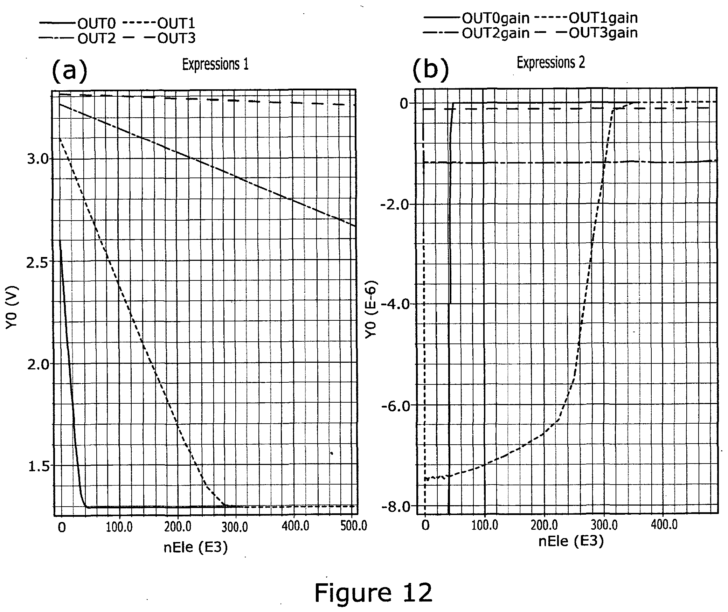

Figure 11 is an expanded version of figure 9, expanded to show the third output phase with a full capacitance of around 2x10⁶ electrons. Figure 12 is a further expanded version of figure 9, expanded to show the gain and full well of the second and third output phases. The gain of the third output phase is approximately 1.2pV/e with a full well of almost 300 hundred thousand electrons. The gain of the second output phase is approximately 7.5µV/e.

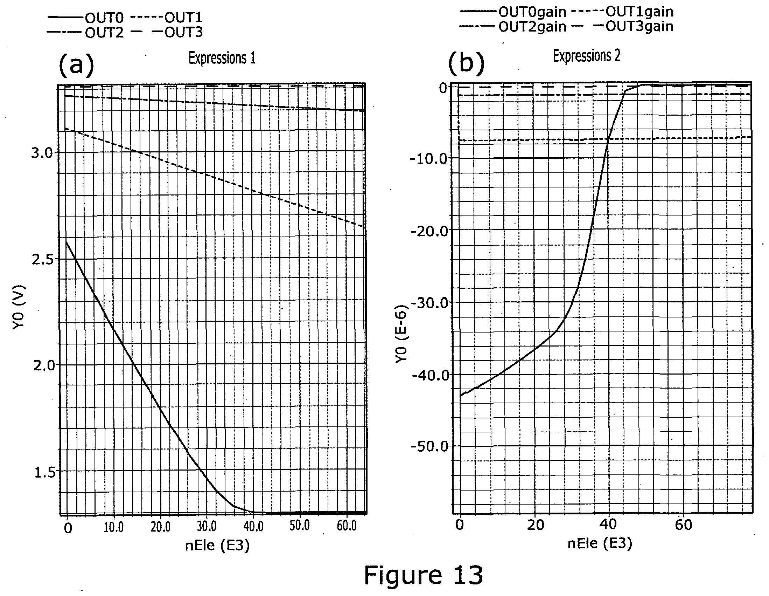

Figure 13 is an even further expanded version of figure 9, expanded to show the gain of the first output phase. The gain of the first output phase is approximately 42pV/e and with a full well of about 35 thousand electrons.

Based on the example of figure 6 having three overflow units, four readout phases are required. Once they are read out of the pixels, these four values could all be read out of the sensor, either in their analogue form or after on-chip digitisation. This is possible but it would require a large bandwidth. Also, as explained above, it is not necessary to read all this information as the best reading is given by the reading corresponding to the highest value of charge which has not saturated the sensor. According to the present invention, a decision block 400 is included to perform this operation and present to the readout pads of the chip only the value corresponding to the best reading.

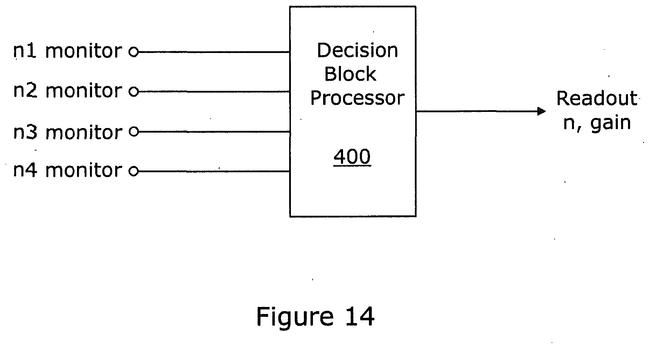

In the embodiment of the present invention shown in figure 14 the decision block 400 monitors the voltage at each node n1, n2, n3 and n4. At the end of the integration period the decision block 400 checks to see if any of the overflow units or the photodiode are full. If any are full then the next unfilled or partially filled overflow unit in the series is readout. The amount of charge stored at a full photodiode or overflow unit will be determined by the size of the capacitance for storage and so will be known without requiring readout. Thus, only reading out any unfilled overflow units and recording which unit is being readout allows the amount of charge to be uniquely determined. Instead of sending an indication of which overflow unit or photodiode is being readout, the gain value for that unit could instead be sent.

The decision block 400 would reduce the readout time by around a half or more by requiring only a single readout phase. Correspondingly only a single value will need to be sent to an analogue-to-digital converter (ADC), along with an indication of the selected readout unit or its gain, thereby reducing dataflow.

The decision block could be located in pixel, at the periphery of the sensor but off pixel, or off the sensor chip. A single decision block could be used for each column or row of the array.

In a simplified decision block according to an example, each of the photodiode and overflow units are readout in accordance with figure 7, such that analogue values are sent off pixel. However, only the value for the smallest unfilled overflow unit or the photodiode is passed to the analogue-to-digital converter. While this does not significantly reduce readout time, it does significantly reduce the amount of data that needs to be transmitted. Again, the gain value for the readout storage unit will also need to be transmitted. This way of reading corresponds to a significant compression in the data. While for example, it is possible to design a sensor where each reading has a 12-bit accuracy and the full dynamic range, defined as the largest full well divided by the intrinsic noise corresponding to the most precise reading, is over 20 bits, the decision block would compress the data into 12 bits for the selected reading plus 2 bits of information on which reading was selected, thus achieving an almost twofold compression ratio.

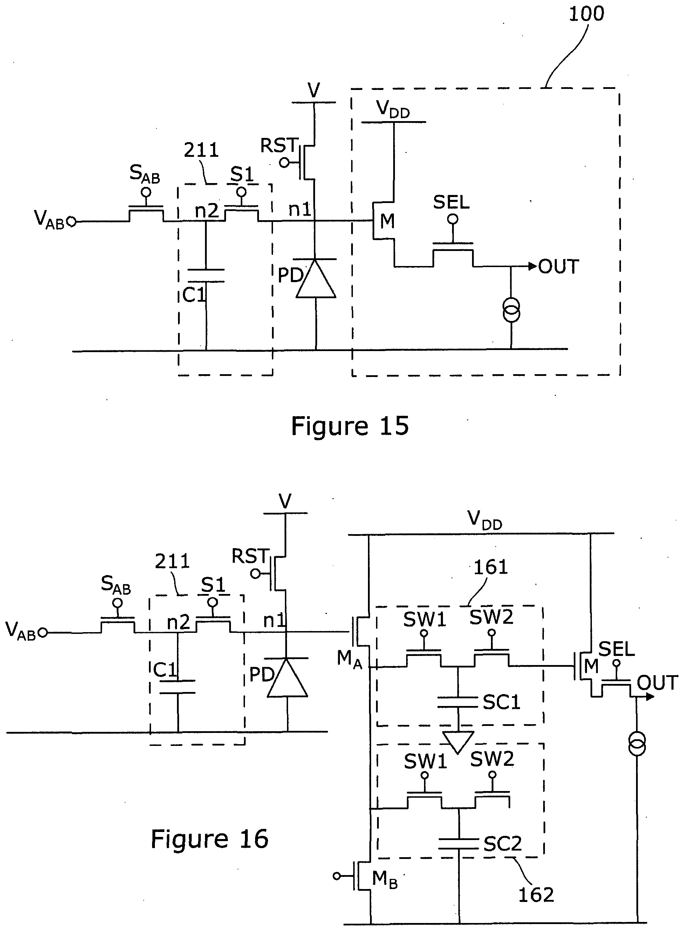

Another example is shown in figure 15. In this example an anti-blooming function is included. The anti-blooming function provides a way of getting rid of any excess charge provided to the capacitor C1, in case this capacitor is driven beyond saturation by the incoming radiation. In the example of figure 15, the readout circuitry 100, photodiode PD, and reset transistor RST are all the same as provided in the examples of figures 3a and 6. An overflow unit 211 is provided which is similar to that of figure 3a, comprising a switch S1 and capacitor C1. Although only one overflow unit is shown in figure 15, any number of overflow units may be provided, for example three as shown in the example of figure 6.

Overflow unit 211 of figure 15 is connected to node n1 as described above and includes a node n2 between the capacitor C1 and switch S1. The circuitry of the anti-blooming function is coupled to the node n2. The anti-blooming circuitry comprises a switch S_{AB} and a relatively high voltage source such as 3.3V. In operation the photodiode PD fills with charge as described above and any excess charge overflows into the overflow unit 211. When the overflow unit 211 itself is also full, further excess charge overflows through the switch S_{AB} which turns on in the same manner as switches S1-S3 of the example of figure 6. This further excess charge simply flows to voltage source V_{AB}. Readout of the photodiode and overflow unit occurs in the same manner as described above. However, the charge that has overflowed to the anti-blooming circuitry cannot be readout as this charge has not been stored.

As mentioned above, the anti-blooming function can be used in combination with any number of overflow units. Under normal operation it is expected that the dynamic range of the sensor including overflow units will be sufficient to store the charge accumulated during the integration period. The anti-blooming function is used when the photogenerated charge exceeds this amount and allows the excess charge to be dissipated preventing charge being accumulated in unwanted parts of the circuitry and causing damage or obscuring normal functioning. The anti-blooming arrangement allows dynamic range to be maximised by the use of overflow units.

A further example outside the scope of the present invention is shown in figure 16. This example includes synchronised data capture or a synchronised snapshot to be taken. As described above in relation to the prior art, all pixels in a column may be readout at the same time. This may be arranged by turning on all select transistors SEL of a column at the same time. Having read out all pixels of a column, the next column is read out in a corresponding manner. This arrangement means that each pixel in a row is read out at slightly different times. This arrangement is known as a rolling shutter. The result is that the end of the integration time for each column is staggered with respect to others to allow readout to also be staggered. This can result in blurring of the image across the pixel array, because as objects being imaged move across the object plane the movement is detected. For example, a first column might detect the object at a first position and this is readout. The object might continue to move and be detected by a second column at a second position before the integration time of the second column completes. Hence, when the image of the complete image plane is formed, the object will be seen at multiple positions staggered or blurred across the image.

The present example synchronises the end of the integration period for all pixels to avoid the problems of a rolling shutter. Readout takes the place using the same procedure as described above and so storage devices are included to allow the charge collected during one integration period to be stored until readout. This may even be arranged such that a second integration period commences before completion of readout of the charge stored from the first integration period.

The circuit of this example is shown schematically in figure 16. The circuit is based on that of figure 15 and includes a first overflow unit and anti-blooming circuitry. In alternative examples the circuit might include any number of overflow units and may or may not include the anti-blooming circuitry. As shown in figure 16, node n1 is connected to the gate of transistor M_{A} in the same way as it is connected to buffer transistor M in other examples. However, the drain of transistor M_{A} is connected to further transistor M_{B}, which acts as a current source. The drain of transistor M_{B} is connected to ground. Between transistors M_{A} and M_{B} are connected first and second storage units 161, 162. Each storage unit comprises a pair of transistors which act as switches. Between the switches is a storage device such as capacitor SC1, SC2. The two storage units 161, 162 are included such that there is a storage unit for the photodiode and the single overflow unit. For examples with more than one overflow unit, additional storage units will be required, such that there is a storage unit for the photodiode and each of the overflow units. The output of each storage unit is connected to the buffer transistor M.

Operation of the storage units for the synchronised data capture arrangement will now be described. Photogenerated charge is generated as described previously and is stored at the photodiode until the charge overflows into the first overflow unit. Synchronisation is achieved by triggering turning on of the first transistor of one of the storage units for all pixels at the same time. This stores a voltage representative of the voltage at node n1 at the same time for all pixels. The storing of voltage is similar to the readout by turning on of the select transistor SEL in the example of figure 15.

As mentioned above, the voltage at node n1 representative of the charge stored across the photodiode is readout to the storage unit. This occurs through transistor M_{A}. The process for transferring the charge stored at the photodiode and first overflow unit is as follows.

Firstly, at the end of the integration period the switch SW1 of first storage unit 161 is turned on and a voltage representative of the charge across the photodiode is stored at storage device SC1 of first storage unit. During this time second switch SW2 of first storage unit remains turned off. Switch S1 of overflow unit is then turned on and a voltage representative of the charge stored across capacitance C1 is readout through transistor M_{A} by turning on first switch SW3 of second storage unit 162. During readout of capacitance C1 first switch SW1 of first storage unit is turned off. After readout of photodiode and first overflow unit, they can be reset and the next integration period can begin.

The storage units 161, 162 can be readout any time after the voltage has been transferred to them and before the next integration period is complete. For readout the second switch of the storage units is turned on along with the select transistor SEL. For example, readout may commence by readout of the voltage representative of the photodiode charge. This readout is performed by turning on second switch SW2 of first storage unit and select transistor SEL. Second switch SW2 is then turned off and readout of the voltage representative of the overflow unit charge can begin. This readout is performed by turning on second switch SW4 of second storage unit and select transistor SEL. The storage units are not required to be reset after readout as any voltage stored will be overwritten in the next period, when the capacitor C1 or photodiode PD is read to them.

The use of storage units 161, 162 permits the integration period to be decoupled from the readout period, provided that readout occurs before the next integration period commences.

In the above described examples and embodiments a single pixel of a sensor array has been described. In another example, outside the scope of the present invention, a single pixel sensor is provided based on a single pixel of the arrays described above. For example, the single pixel sensor may have any combination of one or more overflow units, a decision block, or anti-blooming circuitry. Reset, integration and readout will be as described above, except that the select transistor SEL used during readout will be not be coupled to other pixels.

It will be appreciated by those skilled in the art that only a small number of possible embodiments have been described and that many variations and modifications are possible within the scope of the invention. For example other fabrication technologies and drive voltages may be used in place of or in addition to 3.3V or 7V CMOS. It will also be appreciated by those skilled in the art that modifications to the circuits can be made without departing from the scope of the claimed invention.

## Claims

1. A sensor array comprising an array of pixels, each pixel comprising:
a photodiode (PD);
a node (n1) arranged to develop a voltage based on charge accumulated at the photodiode (PD) due to photogeneration during an integration period; and
a first overflow unit (201) coupled to the node (n1), the first overflow unit comprising a first transistor (S1) and a first capacitance (C1), the sensor array being arranged to control the first overflow unit (201) to accept overflow charge from the node (n1) into the capacitance (C1) of the first overflow unit (201),
each pixel comprising one or more further overflow units (202, 203) arranged in series with the first overflow unit (201), each further overflow unit comprising a further transistor (S2, S3) and a further capacitance (C2, C3),
the first overflow unit (201) and the one or more further overflow units (202, 203) each comprising a node (n2, n3, n4) formed at a connection between the transistor and capacitance of the respective overflow unit, the one or more further overflow units (202, 203) connected to node (n2, n3) of a respective preceding overflow unit in the series,
the sensor array being arranged to control each further overflow unit to accept overflow charge from the previous overflow unit in the series, and to subsequently read the charge at the photodiode (PD), overflow charge stored at the first capacitance (C1) or overflow charge stored at the further capacitance (C2, C3) of the one or more further overflow units,
the sensor array **characterised by** further comprising a decision block (400) arranged to monitor the voltage at each node (n1, n2, n3, n4) and at the end of the integration period check if any of the overflow units (201, 202, 203) or the photodiode (PD) are full of charge, and if any of the overflow units or photodiode are full to readout only a next unfilled or partially filled overflow unit in the series.

2. The sensor array of claim 1, wherein the first transistor (S1) is arranged to control charge collection to, and readout of charge from, the first capacitance (C1).

3. The sensor array of claim 1 or claim 2, wherein the first transistor (S1) of the first overflow unit (201) is arranged to allow charge to flow to the first capacitance (C1) of the first overflow unit after the photogenerated voltage at the node exceeds a threshold.

4. The sensor array of any of claims 1 to 3, wherein the further transistor (S2, S3) is arranged to control charge collection to, and readout of charge from, the further capacitance (C2, C3).

5. The sensor array of claim 1 or claim 4, wherein the further transistor (S2, S3) of the further overflow unit (202, 203) is arranged to allow charge to flow to the capacitance (C2, C3) of the further overflow unit after the voltage across the capacitance of the previous overflow unit in the series has exceeded a threshold.

6. The sensor array of any of claims 1, 4 and 5, wherein each further capacitance (C2, C3) of each further overflow unit (202, 203) has a greater value than the capacitance of the previous overflow unit in the series.

7. The sensor array of any of claims 1 to 6, each pixel further comprising an anti-blooming switch (S_{AB}) coupled to the node (n3, n4) of the last overflow unit in the series if a plurality of overflow units are present, the anti-blooming switch arranged to turn on when the stored charge at all of the photodiode, first overflow unit and any further overflow units exceeds a maximum stored charge.

8. The sensor array of claim 7, wherein the anti-blooming switch is coupled to a voltage (V_{AB}) for receiving any charge in excess of the maximum stored charge.

9. A method of operating the sensor array of any of claims 1 to 8, the method comprising:
resetting pixels of the array by turning on a reset switch (RST) and transistor (S1) of the first overflow unit (201) to supply a predetermined voltage (V) across the photodiode (PD) and the capacitance (C1) of the first overflow unit;
when reset is complete, turning off the reset switch (RST) and transistor (S1) of the first overflow unit (201);
accumulating photogenerated charge at the photodiode (PD);
the transistor (S1) of the first overflow unit (201) operating in sub-threshold to allow the photogenerated charge to overflow from the photodiode (PD);
accumulating overflow charge at the first overflow unit, wherein the charge accumulation continues until an integration period is complete; and
**characterised by** the decision block (400) monitoring the voltage at each node (n1, n2, n3, n4) and at the end of the integration period checking if any of the overflow units (201, 202, 203) or the photodiode (PD) are full of charge, and if any of the overflow units or photodiode are full reading out only a next unfilled or partially filled overflow unit in the series.

## Patentansprüche

1. Sensorarray mit einem Array von Pixeln, wobei jedes Pixel umfasst:
eine Photodiode (PD);
einen Knoten (n1), der eingerichtet ist, um basierend auf der an der Photodiode (PD) durch Photogenerierung während einer Integrationsperiode akkumulierten Ladung eine Spannung aufzubauen; und
eine mit dem Knoten (n1) gekoppelte erste Überlaufeinheit (201), wobei die erste Überlaufeinheit einen ersten Transistor (S1) und eine erste Kapazität (C1) umfasst, wobei das Sensorarray eingerichtet ist, die erste Überlaufeinheit (201) so zu steuern, dass sie Überlaufladung von dem Knoten (n1) in die Kapazität (C1) der ersten Überlaufeinheit (201) aufnimmt,
wobei jedes Pixel ein oder mehrere weitere Überlaufeinheiten (202, 203) umfasst, die in Reihe mit der ersten Überlaufeinheit (201) angeordnet sind, und jede weitere Überlaufeinheit einen weiteren Transistor (S2, S3) und eine weitere Kapazität (C2, C3) umfasst,
wobei die erste Überlaufeinheit (201) und die ein oder mehreren weiteren Überlaufeinheiten (202, 203) jeweils einen Knoten (n2, n3, n4) umfassen, der an einer Verbindung zwischen dem Transistor und der Kapazität der jeweiligen Überlaufeinheit ausgebildet ist, wobei die ein oder mehreren weiteren Überlaufeinheiten (202, 203) mit dem Knoten (n2, n3) einer jeweils vorhergehenden Überlaufeinheit in der Reihe verbunden sind,
wobei das Sensorarray eingerichtet ist, jede weitere Überlaufeinheit so zu steuern, dass sie Überlaufladung von der in der Reihe vorhergehenden Überlaufeinheit annimmt und anschließend die Ladung an der Photodiode (PD), an der ersten Kapazität (C1) gespeicherte Überlaufladung oder an der weiteren Kapazität (C2, C3) der ein oder mehreren weiteren Überlaufeinheiten gespeicherte Überlaufladung auszulesen,
wobei das Sensorarray **dadurch gekennzeichnet ist, dass** es ferner einen Entscheidungsblock (400) umfasst, der eingerichtet ist, die Spannung an jedem Knoten (n1, n2, n3, n4) zu überwachen und am Ende der Integrationsperiode zu prüfen, ob eine der Überlaufeinheiten (201, 202, 203) oder die Photodiode (PD) voll mit Ladung ist, und wenn eine der Überlaufeinheiten oder die Photodiode voll ist, nur eine nächste ungefüllte oder teilweise gefüllte Überlaufeinheit in der Reihe auszulesen.

2. Sensorarray nach Anspruch 1, bei dem der erste Transistor (S1) eingerichtet ist, das Sammeln von Ladung in die erste Kapazität (C1) und das Auslesen von Ladung aus dieser zu steuern.

3. Sensorarray nach Anspruch 1 oder Anspruch 2, bei dem der erste Transistor (S1) der ersten Überlaufeinheit (201) eingerichtet ist, um Ladung zu der ersten Kapazität (C1) der ersten Überlaufeinheit fließen zu lassen, nachdem die photogenerierte Spannung an dem Knoten einen Schwellenwert überschreitet.

4. Sensorarray nach einem der Ansprüche 1 bis 3, bei dem der weitere Transistor (S2, S3) eingerichtet ist, das Sammeln von Ladung in die weitere Kapazität (C2, C3) und das Auslesen von Ladung aus dieser zu steuern.

5. Sensorarray nach Anspruch 1 oder Anspruch 4, bei dem der weitere Transistor (S2, S3) der weiteren Überlaufeinheit (202, 203) eingerichtet ist, um Ladung zu der Kapazität (C2, C3) der weiteren Überlaufeinheit fließen zu lassen, nachdem die Spannung über der Kapazität der in der Reihe vorhergehenden Überlaufeinheit einen Schwellenwert überschritten hat.

6. Sensorarray nach einem der Ansprüche 1, 4 und 5, bei dem jede weitere Kapazität (C2, C3) jeder weiteren Überlaufeinheit (202, 203) einen größeren Wert hat als die Kapazität der in der Reihe vorhergehenden Überlaufeinheit.

7. Sensoranordnung nach einem der Ansprüche 1 bis 6, bei dem jedes Pixel ferner einen Anti-Blooming-Schalter (Sab) umfasst, der, wenn eine Mehrzahl von Überlaufeinheiten vorhanden ist, mit dem Knoten (n3, n4) der letzten Überlaufeinheit in der Reihe gekoppelt ist, und der Anti-Blooming-Schalter eingerichtet ist, sich einzuschalten, wenn die gespeicherte Ladung der Photodiode, der ersten Überlaufeinheit und allen weiteren Überlaufeinheiten zusammen eine maximale gespeicherte Ladung überschreitet.

8. Sensorarray nach Anspruch 7, bei dem der Anti-Blooming-Schalter mit einer Spannung (Vab) zum Empfangen jeglicher Ladung, die die maximale gespeicherte Ladung überschreitet, gekoppelt ist.

9. Verfahren zum Betreiben des Sensorarrays nach einem der Ansprüche 1 bis 8, wobei das Verfahren umfasst:
Rücksetzen von Pixeln des Arrays durch Einschalten eines Rücksetzschalters (RST) und eines Transistors (S1) der ersten Überlaufeinheit (201), um eine vorgegebene Spannung (V) über der Photodiode (PD) und der Kapazität (C1) der ersten Überlaufeinheit zu liefern;
wenn das Rücksetzen abgeschlossen ist, Ausschalten des Rücksetzschalters (RST) und des Transistors (S1) der ersten Überlaufeinheit (201);
Akkumulieren von photogenerierter Ladung an der Photodiode (PD);
Betreiben des Transistors (S1) der ersten Überlaufeinheit (201) im Unterschwellenbereich, um das Überlaufen der photogenerierten Ladung von der Photodiode (PD) zu ermöglichen;
Akkumulieren der Überlaufladung an der ersten Überlaufeinheit, wobei das Akkumulieren der Ladung fortgesetzt wird, bis eine Integrationsperiode abgeschlossen ist; und
**dadurch gekennzeichnet, dass** der Entscheidungsblock (400) die Spannung an jedem Knoten (n1, n2, n3, n4) überwacht und am Ende der Integrationsperiode prüft, ob eine der Überlaufeinheiten (201, 202, 203) oder die Photodiode (PD) voll mit Ladung ist, und wenn eine der Überlaufeinheiten oder die Photodiode voll ist, nur eine nächste ungefüllte oder teilweise gefüllte Überlaufeinheit in der Reihe ausliest.

## Revendications

1. Réseau de capteurs comprenant une matrice de pixels, chaque pixel comprenant :
une photodiode (PD) ;
un nœud (n1) prévu pour développer une tension sur la base d'une charge accumulée au niveau de la photodiode (PD) due à une photogénération pendant une période d'intégration ; et
une première unité de dépassement (201) couplée au nœud (n1), la première unité de dépassement comprenant un premier transistor (S1) et une première capacité (C1), le réseau de capteurs étant prévu pour commander la première unité de dépassement (201) afin qu'elle accepte une charge de dépassement en provenance du nœud (n1) dans la capacité (C1) de la première unité de dépassement (201),
chaque pixel comprenant une ou plusieurs unités de dépassement supplémentaires (202, 203) en série avec la première unité de dépassement (201), chaque unité de dépassement supplémentaire comprenant un transistor supplémentaire (S2, S3) et une capacité supplémentaire (C2, C3),
la première unité de dépassement (201) et les une ou plusieurs unités de dépassement supplémentaires (202, 203) comprenant chacune un nœud (n2, n3, n4) formé au niveau d'une connexion entre le transistor et la capacité de l'unité de dépassement respective, les une ou plusieurs unités de dépassement supplémentaires (202, 203) étant connectées au nœud (n2, n3) d'une unité de dépassement précédente respective dans la série,
le réseau de capteurs étant prévu pour commander chaque unité de dépassement supplémentaire afin qu'elle accepte une charge de dépassement provenant de l'unité de dépassement précédente dans la série, et pour lire ensuite la charge au niveau de la photodiode (PD), une charge de dépassement stockée au niveau de la première capacité (C1) ou une charge de dépassement stockée au niveau de l'autre capacité (C2, C3) des une ou plusieurs unités de dépassement supplémentaires,
le réseau de capteurs étant **caractérisé en ce qu'**il comprend en outre un bloc de décision (400) prévu pour surveiller la tension au niveau de chaque nœud (n1, n2, n3, n4) et, à la fin de la période d'intégration, pour vérifier si l'une quelconque des unités de dépassement (201, 202, 203) ou la photodiode (PD) est pleine de charge, et si l'une quelconque des unités de dépassement ou la photodiode est pleine, pour lire uniquement une unité de dépassement suivante non remplie ou partiellement remplie dans la série.

2. Réseau de capteurs selon la revendication 1, dans lequel le premier transistor (S1) est prévu pour commander une collecte de charge vers la première capacité (C1) et une lecture de charge à partir de celle-ci.

3. Réseau de capteurs selon la revendication 1 ou la revendication 2, dans lequel le premier transistor (S1) de la première unité de dépassement (201) est prévu pour permettre à une charge de s'écouler vers la première capacité (C1) de la première unité de dépassement après que la tension photogénérée au niveau du nœud dépasse un seuil.

4. Réseau de capteurs selon l'une quelconque des revendications 1 à 3, dans lequel le transistor supplémentaire (S2, S3) est prévu pour commander la collecte de charge vers la capacité supplémentaire (C2, C3) et la lecture de charge à partir de celle-ci.

5. Réseau de capteurs selon la revendication 1 ou la revendication 4, dans lequel le transistor supplémentaire (S2, S3) de l'unité de dépassement supplémentaire (202, 203) est prévu pour permettre à la charge de s'écouler vers la capacité (C2, C3) de l'unité de dépassement supplémentaire après que la tension aux bornes de la capacité de l'unité de dépassement précédente dans la série a dépassé un seuil.

6. Réseau de capteurs selon l'une quelconque des revendications 1, 4 et 5, dans lequel chaque capacité supplémentaire (C2, C3) de chaque unité de dépassement supplémentaire (202, 203) a une valeur supérieure à la capacité de l'unité de dépassement précédente dans la série.

7. Réseau de capteurs selon l'une quelconque des revendications 1 à 6, chaque pixel comprenant en outre un commutateur anti-éblouissement (S_{AB}) couplé au nœud (n3, n4) de la dernière unité de dépassement de la série si une pluralité d'unités de dépassement sont présentes, le commutateur anti-éblouissement étant prévu pour s'allumer lorsque la charge stockée au niveau de la totalité de la photodiode, de la première unité de dépassement et de toute unité de dépassement supplémentaire dépasse une charge stockée maximale.

8. Réseau de capteurs selon la revendication 7, dans lequel le commutateur anti-éblouissement est couplé à une tension (V_{AB}) pour recevoir toute charge en excès de la charge stockée maximale.

9. Procédé de fonctionnement du réseau de capteurs selon l'une quelconque des revendications 1 à 8, le procédé comprenant les étapes consistant à :
réinitialiser des pixels du réseau en allumant un commutateur de réinitialisation (RST) et un transistor (S1) de la première unité de dépassement (201) pour fournir une tension prédéterminée (V) aux bornes de la photodiode (PD) et de la capacité (C1) de la première unité de débordement ;
lorsque la réinitialisation est terminée, éteindre le commutateur de réinitialisation (RST) et le transistor (S1) de la première unité de dépassement (201) ;
accumuler une charge photogénérée au niveau de la photodiode (PD) ;
le transistor (S1) de la première unité de dépassement (201) fonctionnant en sous-seuil pour permettre à la charge photogénérée de dépasser de la photodiode (PD) ;
accumuler une charge de dépassement au niveau de la première unité de dépassement, dans lequel l'accumulation de charge continue jusqu'à ce qu'une période d'intégration soit terminée ; et
**caractérisé par** le bloc de décision (400) surveillant la tension au niveau de chaque nœud (n1, n2, n3, n4) et à la fin de la période d'intégration, vérifiant si l'une quelconque des unités de dépassement (201, 202, 203) ou la photodiode (PD) est pleine de charge, et si l'une quelconque des unités de dépassement ou la photodiode est pleine, lire seulement une unité de dépassement suivante non remplie ou partiellement remplie dans la série.
